(19) **Europäisches Patentamt / European Patent Office / Office européen des brevets**

(11) **EP 3 401 694 B1**

(12) **FASCICULE DE BREVET EUROPEEN**

(45) Date de publication et mention de la délivrance du brevet:
**12.06.2019 Bulletin 2019/24**

(51) Int Cl.:
*G01R 31/34* (2006.01)          *G01R 27/14* (2006.01)
*H02P 21/14* (2016.01)          *H02P 23/00* (2016.01)
*H02P 23/14* (2006.01)

(21) Numéro de dépôt: **18167159.5**

(22) Date de dépôt: **13.04.2018**

(54) **PROCÉDÉ D'IDENTIFICATION DE LA RÉSISTANCE ÉLECTRIQUE DU ROTOR D'UN MOTEUR ÉLECTRIQUE**

IDENTIFIZIERUNGSVERFAHREN DES ELEKTRISCHEN WIDERSTANDS EINES ROTORS EINES ELEKTROMOTORS

METHOD FOR IDENTIFYING THE ELECTRICAL RESISTANCE OF THE ROTOR OF AN ELECTRIC MOTOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.05.2017 FR 1754076**

(43) Date de publication de la demande:
**14.11.2018 Bulletin 2018/46**

(73) Titulaire: **Schneider Toshiba Inverter Europe SAS 27120 Pacy sur Eure (FR)**

(72) Inventeurs:
• **MALRAIT, François**
  **27120 Jouy sur Eure (FR)**
• **DEVOS, Thomas**
  **78955 Carrières sous Poissy (FR)**
• **JEBAI, Al Kassem**
  **27120 Vernon (FR)**

(74) Mandataire: **Dufresne, Thierry**
  **Schneider Electric Industries SAS**
  **Service Propriété Industrielle**
  **35 rue Joseph Monier - CS 30323**
  **92506 Rueil-Malmaison Cedex (FR)**

(56) Documents cités:
**US-A1- 2014 132 200     US-A1- 2015 177 328**

• **DIAB AHMED A ZAKI ET AL: "Parallel estimation of rotor resistance and speed for sensorless vector controlled induction motor drive", 2016 17TH INTERNATIONAL CONFERENCE OF YOUNG SPECIALISTS ON MICRO/NANOTECHNOLOGIES AND ELECTRON DEVICES (EDM), IEEE, 30 juin 2016 (2016-06-30), pages 389-394, XP032943052, DOI: 10.1109/EDM.2016.7538763**
• **ZAKY MOHAMED S ET AL: "Sensorless Torque/Speed Control of Induction Motor Drives at Zero and Low Frequencies With Stator and Rotor Resistance Estimations", IEEE JOURNAL OF EMERGING AND SELECTED TOPICS IN POWER ELECTRONICS, IEEE, PISCATAWAY, NJ, USA, vol. 4, no. 4, 1 décembre 2016 (2016-12-01), pages 1416-1429, XP011626949, ISSN: 2168-6777, DOI: 10.1109/JESTPE.2016.2597003 [extrait le 2016-10-28]**

EP 3 401 694 B1

**Description**

**Domaine technique de l'invention**

La présente invention se rapporte à un procédé d'identification de la résistance électrique du rotor d'un moteur électrique à induction.

L'invention concerne également le système d'identification permettant de mettre en oeuvre ledit procédé.

**Etat de la technique**

Un moteur électrique est commandé par un variateur de vitesse, mettant en oeuvre une loi de commande adaptée. Pour commander correctement le moteur électrique, le variateur de vitesse et son unité de traitement doivent s'appuyer sur certains paramètres du moteur électrique commandé.

Pour assurer une commande stable et performante, il est préférable que le variateur de vitesse s'appuie sur des paramètres dont les valeurs sont exactes. C'est notamment le cas de la résistance du rotor (appelé également "résistance rotorique") du moteur électrique. Or il s'avère que cette valeur exacte de la résistance du rotor n'est pas forcément connue de l'unité de traitement du variateur de vitesse. L'unité de traitement peut alors par exemple utiliser une valeur par défaut dans la commande, ce qui entraîne très souvent des performances dégradées. La résistance rotorique pourra en effet être sur-estimée ou sous-estimée par l'unité de traitement, entraînant une variation du courant dans le stator et donc une erreur dans la mise en oeuvre de l'algorithme de calcul des tensions de la loi de commande.

Des solutions ont cependant déjà été proposées pour déterminer la résistance du rotor. Certaines de ces solutions consistent à déterminer l'inductance rotorique pour en déduire la résistance rotorique. Cependant, sans rentrer dans les détails, à cause de la saturation magnétique, la valeur de l'inductance rotorique n'est pas forcément constante, ce qui entraîne une erreur dans la détermination de la résistance rotorique.

Le brevet EP1713173B1 décrit pour sa part une solution d'ajustement des paramètres d'un moteur électrique. Elle est mise en oeuvre en ligne, c'est-à-dire lors du fonctionnement normal du moteur. Elle consiste principalement à utiliser le terme intégral de la boucle de courant pour ajuster les valeurs des paramètres du modèle moteur.

Cette solution n'est également pas satisfaisante, notamment car elle doit être mise en oeuvre en présence d'une charge sur le moteur et qu'elle nécessite l'emploi d'un capteur de vitesse (boucle fermée).

La publication référencée "DIAB AHMED A ZAKI et Al, "Parallel estimation of rotor resistance and speed for sensorless vector controlled induction motor drive" - 2016 17TH International Conference of young specialists on Micro/nanotechnologies and electron devices (EDM), IEEE, 30 juin 2016, pages 389-394, XP032943052, DOI : 10.1109/EDM.2016.7538763″décrit un procédé d'identification d'une valeur de résistance du rotor d'un moteur électrique en employant un système adaptatif.

Le but de l'invention est donc de proposer un nouveau procédé pour l'identification de la résistance du rotor, qui soit fiable, ne nécessite pas l'utilisation d'un capteur de vitesse (boucle fermée) et qui puisse être mis en oeuvre en présence d'une charge ou en l'absence d'une charge sur le moteur.

**Exposé de l'invention**

Ce but est atteint par un procédé d'identification d'une valeur de résistance du rotor d'un moteur électrique à induction, ledit procédé comportant les étapes suivantes :

a) Détermination d'une tension de référence en fonction d'une valeur choisie pour la résistance du rotor du moteur électrique,
b) Application d'une tension de commande au moteur électrique, ladite tension de commande étant déterminée à partir de ladite tension de référence,
c) Acquisition des valeurs des courants mesurés dans les trois phases du moteur électrique de manière à en déduire un courant stator du moteur électrique,
d) Comparaison du courant stator obtenu avec une valeur prédéterminée,
e) Correction de ladite valeur utilisée pour la résistance du rotor et application des étapes a) à d) jusqu'à obtenir un courant stator égal à ladite valeur prédéterminée.

Ce but est également atteint par un procédé d'identification d'une valeur de résistance du rotor d'un moteur électrique à induction, ledit procédé comportant les étapes suivantes :

a) Détermination d'une tension de mesure pour laquelle un courant stator représentatif des courants mesurés dans les trois phases du moteur électrique est égal à une valeur prédéterminée,

b) Détermination d'une tension de référence en fonction d'une valeur choisie pour la résistance du rotor du moteur électrique,

c) Comparaison de ladite tension de référence avec la tension de mesure,

d) Correction de ladite valeur utilisée pour la résistance du rotor et application des étapes a) à c) jusqu'à obtenir une égalité entre ladite tension de référence et la tension de mesure.

Selon une particularité, ladite valeur prédéterminée correspond à une valeur nulle ou proche de zéro.

Selon une réalisation particulière, le procédé est mis en oeuvre selon un principe de dichotomie comprenant plusieurs itérations successives et dans lequel, à chaque itération, un intervalle dans lequel se trouve la valeur recherchée pour la résistance du rotor est divisée par deux.

Selon une autre réalisation particulière, le procédé est mis en oeuvre selon un principe de gradient comprenant plusieurs itérations successives et dans lequel la valeur choisie pour la résistance du rotor est modifiée à chaque itération selon le sens du résultat de l'étape de comparaison.

Le but est également atteint par un système d'identification d'une valeur de résistance du rotor d'un moteur électrique à induction, qui comporte :

a) Un module de détermination d'une tension de référence en fonction d'une valeur choisie pour la résistance du rotor du moteur électrique,

b) Un module d'application de tensions de commande au moteur électrique, lesdites tensions de commande étant déterminées à partir de ladite tension de référence,

c) Un module d'acquisition des valeurs des courants mesurés dans les trois phases du moteur électrique de manière à en déduire un courant stator du moteur électrique,

d) Un module de comparaison du courant stator obtenu avec une valeur prédéterminée,

e) Un module de correction de ladite valeur utilisée pour la résistance du rotor et exécution des modules a) à d) jusqu'à obtenir un courant stator égal à ladite valeur prédéterminée.

Le but est également atteint par un système d'identification d'une valeur de résistance du rotor d'un moteur électrique à induction, qui comporte :

a) Un module de détermination d'une tension de mesure pour laquelle un courant stator représentatif des courants mesurés dans les trois phases du moteur électrique est égal à une valeur prédéterminée,

b) Un module de détermination d'une tension de référence en fonction d'une valeur choisie pour la résistance du rotor du moteur électrique,

c) Un module de comparaison de ladite tension de référence avec la tension de mesure,

d) Un module de correction de ladite valeur utilisée pour la résistance du rotor et application des étapes a) à c) jusqu'à obtenir une égalité entre ladite tension de référence et la tension de mesure.

Selon une particularité, ladite valeur prédéterminée correspond à une valeur nulle ou proche de zéro.

Selon une réalisation particulière, ce système est configuré pour fonctionner selon un principe de dichotomie comprenant plusieurs itérations successives et dans lequel, à chaque itération, un intervalle dans lequel se trouve la valeur recherchée pour la résistance du rotor est divisée par deux.

Selon une autre réalisation particulière, le système est configuré pour fonctionner selon un principe de gradient comprenant plusieurs itérations successives et dans lequel la valeur choisie pour la résistance du rotor est modifiée à chaque itération selon le sens du résultat de l'étape de comparaison.

L'invention concerne enfin un variateur de vitesse destiné à la commande d'un moteur électrique, qui comporte un système de commande comprenant un système d'identification conforme à celui défini ci-dessus.

**Brève description des figures**

D'autres caractéristiques et avantages vont apparaître dans la description détaillée qui suit, faite en regard des dessins annexés dans lesquels :

- La figure 1 représente le schéma d'un variateur de vitesse classique incluant le système de commande de l'invention.
- La figure 2 représente un synoptique illustrant le principe de fonctionnement du procédé de commande de l'invention.
- La figure 3 représente de manière schématique le principe du procédé d'identification de l'invention.
- La figure 4 illustre le principe de recherche par dichotomie de la valeur de la résistance rotorique.
- La figure 5 illustre, selon un mode de réalisation particulier, le principe de fonctionnement du procédé d'identification de l'invention.

**Description détaillée d'au moins un mode de réalisation**

L'invention décrite ci-dessous s'applique à la commande d'un moteur M asynchrone (à induction), préférentiellement à alimentation triphasée. Elle est mise en oeuvre dans un schéma de commande classique de type vectoriel ou scalaire, en boucle ouverte, c'est-à-dire sans retour d'une mesure de vitesse au niveau du moteur électrique, ou en boucle fermée, c'est-à-dire avec retour d'une mesure de vitesse au niveau du moteur électrique.

Le procédé d'identification de l'invention est mis en oeuvre dans un système de commande qui comporte une unité de traitement UC. L'unité de traitement UC comporte au moins un microprocesseur et une mémoire. Ce système de commande est associé à un variateur de vitesse destiné à la commande d'un moteur électrique. Il pourra notamment être intégré audit variateur de vitesse.

De manière connue, le variateur de vitesse comporte en règle générale :

- Des phases d'entrée R, S, T connectées à un réseau électrique fournissant une tension alternative ;
- Un redresseur AC/DC 10, tel que par exemple un pont de diodes, destiné à transformer la tension alternative fournie par le réseau électrique en une tension continue ;
- Un bus continu d'alimentation connecté en sortie du redresseur et comportant deux lignes d'alimentation entre lesquelles est appliquée la tension continue ;
- Au moins un condensateur de bus Cbus connecté entre les deux lignes d'alimentation du bus et destiné à maintenir la tension continue à une valeur constante ;
- Un onduleur DC/AC 11 connecté au bus continu d'alimentation et comprenant plusieurs transistors de puissance, par exemple de type IGBT, commandés par l'unité de traitement de manière à appliquer les tensions requises sur des phases de sortie connectées au moteur électrique. La commande de l'onduleur 11 est par exemple réalisée par des techniques traditionnelles de type MLI (Modulation à Largeur d'Impulsion) ou CDC (Contrôle Direct de Couple). Une loi de commande exécutée par l'unité de traitement UC permet de déterminer les tensions à appliquer sur les phases de sortie ;
- Des phases de sortie 1, 2, 3 destinées à être connectées au moteur électrique M à commander.

De manière non limitative, l'invention sera décrite pour une loi de commande de type scalaire en U/F et en boucle ouverte. Il faut comprendre que la méthode décrite ci-dessous sera identique quelle que soit la loi de commande employée.

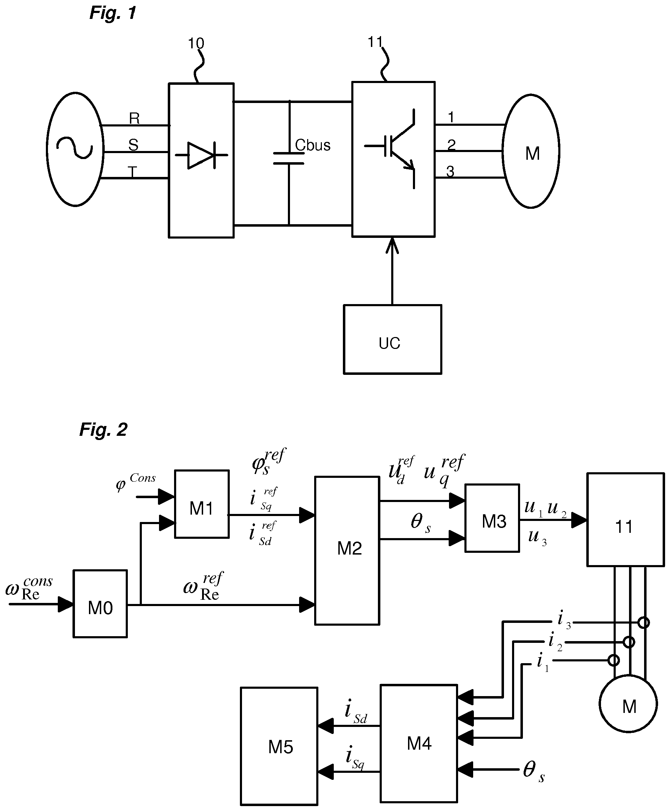

De manière connue, en référence à la figure 2, une loi de commande scalaire en U/F classique, exécutée par l'unité de traitement pour la commande d'un moteur électrique asynchrone en boucle ouverte, comporte les caractéristiques principales suivantes :

- Une consigne de pulsation du rotor du moteur électrique $\omega_{Re}^{cons}$, et une consigne de flux $\varphi^{cons}$ sont appliquées en entrée ;

- Un module M0 détermine une référence de pulsation du rotor $\omega_{Re}^{ref}$ du moteur électrique à partir de la consigne de pulsation du rotor $\omega_{Re}^{cons}$ du moteur électrique reçue en entrée ;

- Un module M1 calculateur, recevant en entrée une consigne de flux $\varphi^{cons}$ et la référence de pulsation du rotor $\omega_{Re}^{Ref}$, détermine les courants statoriques de référence $i_{Sd}^{ref}$ et $i_{Sq}^{ref}$ ainsi que le flux statorique de référence $\varphi_S^{ref}$ ;

- Un module M2, recevant en entrée la référence de pulsation du rotor $\omega_{Re}^{ref}$, le flux statorique de référence $\varphi_S^{ref}$ et les courants de référence $i_{Sd}^{ref}$ et $i_{Sq}^{ref}$, détermine les tensions $u_d^{ref}$ et $u_q^{ref}$ à appliquer au moteur électrique, et l'angle d'orientation $\theta_s$ à appliquer ;

- Un module M3 applique une transformation de Park pour déterminer les tensions $u_1$, $u_2$, $u_3$ à appliquer sur les trois phases de sortie ;

- Dans le cadre de l'invention, au moins deux des trois courants $i_1$, $i_2$, $i_3$ sont mesurés sur les trois phases du moteur électrique, en vue d'en déduire les courants $i_{Sd}$ et $i_{Sq}$ par un module M4 recevant également en entrée l'angle d'orientation $\theta_s$.

D'autres modules peuvent bien entendu être mis en oeuvre par l'unité de traitement mais ceux-ci ne seront pas détaillés dans la présente demande.

Cette loi de commande est mise en oeuvre lors d'une phase d'exploitation, c'est-à-dire pendant le fonctionnement normal du moteur électrique M commandé par le variateur de vitesse.

L'invention concerne plus particulièrement un procédé d'identification de la résistance du rotor du moteur électrique. Cette identification peut être mise en oeuvre préalablement au fonctionnement normal du moteur ou à tout autre moment lors d'une phase de paramétrage du variateur de vitesse.

Le procédé d'identification est mis en oeuvre par un système d'identification, préférentiellement exécuté par l'unité de traitement UC du variateur de vitesse. Ce système d'identification s'appuie notamment sur les modules M1 à M4 du système de commande et sur un module M5 complémentaire aidant à l'identification de la résistance du rotor. Les moyens de mesure de courant et de tension seront avantageusement intégrés au système d'identification de l'invention et les étapes de mesure mises en oeuvre feront avantageusement partie du procédé d'identification de l'invention.

Pour sa mise en oeuvre, le procédé d'identification s'appuie sur les démonstrations suivantes dans lesquelles l'indice "R" permet d'identifier les paramètres liés au rotor, l'indice "S" permet d'identifier des paramètres liés au stator, l'exposant "ref" permet d'identifier un paramètre de référence.

La tension stator de référence $u_S^{ref}$ est calculée par la formule :

$$u_S^{ref} = j \cdot \omega_S \cdot \varphi_S^{ref} + \frac{d}{dt} \varphi_S^{ref} \qquad (1)$$

où, par construction la tension stator de référence est écrite en complexe à partir des deux composantes d'axe d et d'axe q comme suit :

$$u_S^{ref} = u_d^{ref} + j \cdot u_q^{ref}$$

La relation dynamique au rotor est donnée par l'équation suivante :

$$\frac{d}{dt} \varphi_R^{ref} = -R_r \cdot i_R^{ref} \qquad (2)$$

Nous cherchons à créer une tension qui annule les courants statoriques, i.e. $i_{Sd}^{ref} = 0$ et $i_{Sq}^{ref} = 0$.

De la même manière que pour la tension, l'écriture complexe des courants statoriques est :

$$i_S^{ref} = i_{Sd}^{ref} + j \cdot i_{Sq}^{ref} = 0$$

Le couplage magnétique du moteur fournit les relations suivantes :

$$\begin{cases} \varphi_S^{ref} = \varphi_M^{ref} \\ \varphi_R^{ref} = L_{FR} \cdot i_R^{ref} + \varphi_M^{ref} \end{cases}$$

Où:

$$\varphi_M^{ref} = f\left(i_R^{ref}\right)$$

Comme exemple, la fonction de saturation peut être représentée par la fonction f suivante :

$$f\left(i_R^{ref}\right) = L_{SAT} \cdot i_R^{ref} \cdot \frac{1}{1 + \gamma \cdot \left|i_R^{ref}\right|}$$

Dans lesquelles :

- $\omega_s$ correspond à la pulsation de la tension (dérivée de l'angle d'orientation $\theta_s$);
- $\varphi_M^{ref}$ correspond au flux magnétisant de référence, sans perte de généralité représenté par une grandeur réelle ;
- $\varphi_R^{ref}$ correspond au flux rotor de référence, sans perte de généralité représenté par une grandeur réelle ;
- $i_S^{ref}$ correspond au courant stator de référence, égal à 0 ;
- $i_R^{ref}$ correspond au courant rotor de référence, sans perte de généralité, représenté par une grandeur réelle ;
- $R_r$ correspond à la résistance du rotor (ou "résistance rotorique") ;
- $L_{FR}$ correspond à l'inductance de fuite rotor ;
- $L_{SAT}$ et $\gamma$ correspondent à des paramètres de saturation magnétique du moteur électrique pour la fonction f décrite.

En remplaçant $\varphi_R^{ref}$ par son expression, il vient :

$$\frac{d}{dt}\varphi_R^{ref} = \left( L_{FR} + \frac{d\varphi_M^{ref}}{di_R^{ref}} \right) \cdot \frac{d}{dt} i_R^{ref} \qquad (3)$$

En calculant la dérivée de la fonction de saturation magnétique f, nous obtenons :

$$\frac{d\varphi_M^{ref}}{di_R^{ref}} = f'\left(i_R^{ref}\right) = L_{SAT} \cdot \frac{1}{\left(1 + \gamma \cdot i_R^{ref}\right)^2} \cdot$$

L'algorithme suit les étapes décrites ci-dessous.

La loi d'évolution de $i_R^{ref}$ est la suivante, à partir des équations (2) et (3) :

$$\left( L_{FR} + L_{SAT} \cdot \frac{1}{\left(1 + \gamma \cdot i_R^{ref}\right)^2} \right) \cdot \frac{d}{dt} i_R^{ref} = -R_r \cdot i_R^{ref}$$

Alors, nous pouvons calculer le flux de magnétisation qui est aussi le flux stator :

$$\varphi_M^{ref} = f\left(i_R^{ref}\right) = L_{SAT} \cdot i_R^{ref} \cdot \frac{1}{1 + \gamma \cdot i_R^{ref}}$$

Au final, la tension est calculée à partir du flux stator et de sa dérivée :

$$\frac{d}{dt}\varphi_S^{ref} = f'\left(i_R^{ref}\right) \cdot \frac{d}{dt} i_R^{ref} = -\frac{L_{SAT} \cdot \dfrac{1}{\left(1 + \gamma \cdot i_R^{ref}\right)^2}}{L_{FR} + L_{SAT} \cdot \dfrac{1}{\left(1 + \gamma \cdot i_R^{ref}\right)^2}} \cdot R_r \cdot i_R^{ref},$$

$$\varphi_S^{ref} = f\left(i_R^{ref}\right) = L_{SAT} \cdot i_R^{ref} \cdot \frac{1}{1 + \gamma \cdot i_R^{ref}}$$

Et la tension stator vaut :

$$u_S^{ref} = j \cdot \omega_S \cdot \varphi_S^{ref} + \frac{d}{dt} \varphi_S^{ref}$$

On déduit des relations ci-dessus qu'il existe une relation entre la résistance du rotor et la tension stator de référence $u_S^{ref}$. Il en ressort qu'une variation de la résistance du rotor aura une incidence sur la valeur de cette tension.

A partir de la relation :

$$u_S^{ref} = u_d^{ref} + j \cdot u_q^{ref}$$

Nous en déduisons que :

$$u_d^{ref} = partie\ réelle(u_S^{ref})$$

$$u_q^{ref} = partie\ imaginaire(u_S^{ref})$$

Par la rotation d'un angle $\theta_s$, nous obtenons deux tensions $u_\alpha^{ref}$, $u_\beta^{ref}$ dans le repère fixe. Pour simplifier les calculs, nous introduisons une troisième composante $u_\gamma^{ref}$ égale à 0. Cette composante représente les écarts du moteur au regard d'un modèle standard équilibré. Il ne reste qu'à appliquer la transformation de Clarke pour calculer les tensions $u_1$, $u_2$, $u_3$ :

$$\begin{pmatrix} u_1 \\ u_2 \\ u_3 \end{pmatrix} = \begin{pmatrix} 1 & 0 & \frac{\sqrt{2}}{2} \\ -\frac{1}{2} & \frac{\sqrt{3}}{2} & \frac{\sqrt{2}}{2} \\ -\frac{1}{2} & -\frac{\sqrt{3}}{2} & \frac{\sqrt{2}}{2} \end{pmatrix} \begin{pmatrix} u_\alpha^{Ref} \\ u_\beta^{Ref} \\ u_\gamma^{Ref} \end{pmatrix}$$

D'une manière symétrique, les courants mesurés $i_1$, i2, $i_3$ peuvent être transformés par la transformation de Clarke inversée :

$$\begin{pmatrix} i_\alpha^{Ref} \\ i_\beta^{Ref} \\ i_\gamma^{Ref} \end{pmatrix} = \frac{2}{3} \begin{pmatrix} 1 & -\frac{1}{2} & -\frac{1}{2} \\ 0 & \frac{\sqrt{3}}{2} & -\frac{\sqrt{3}}{2} \\ \frac{\sqrt{2}}{2} & \frac{\sqrt{2}}{2} & \frac{\sqrt{2}}{2} \end{pmatrix} \begin{pmatrix} i_1 \\ i_2 \\ i_3 \end{pmatrix}$$

Puis, à partir de la rotation inverse et des deux composantes tensions $i_\alpha$, $i_\beta$, nous obtenons les deux valeurs de courants . $i_{sd}$ et $i_{sq}$. Le courant $i_s$ est calculé comme une fonction de ces valeurs.

Le principe général de l'invention consiste à mettre en place un algorithme efficace qui permette de converger vers la valeur recherchée de la résistance du rotor $R_r$.

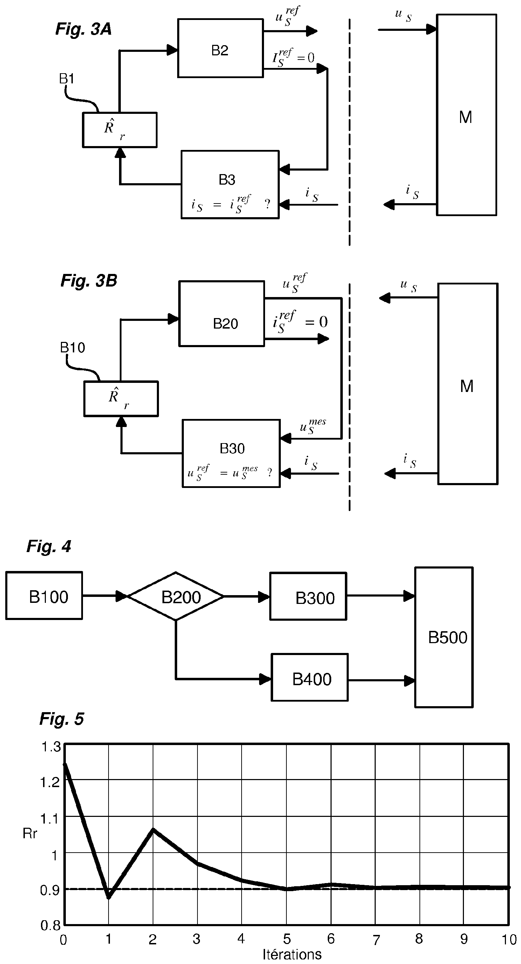

En références aux figures 3A et 3B, deux alternatives sont alors possibles.

Une première alternative illustrée par la figure 3A consiste à suivre le cycle suivant :

- Affecter dans un premier bloc B1 une première valeur théorique $\hat{R}_r$ en entrée de la loi de commande (par exemple en U/F comme décrit ci-dessus) à la variable de résistance du rotor ;

- Déterminer dans un bloc B2 la tension stator de référence $u_s^{ref}$ à partir de cette première valeur $\hat{R}_r$ affectée à la résistance du rotor ;

- Appliquer au moteur les tensions (tension stator $u_s$) calculées à partir de la tension de référence $u_s^{ref}$ ;

- Mesurer les courants $i_1$, $i_2$, $i_3$ dans les trois enroulements du moteur en vue d'en déduire un courant stator $i_s$;

- Comparer dans un bloc B3 le courant stator Is obtenu avec une valeur prédéterminée de référence (par exemple $i_s^{ref} = 0$);

- Recommencer le cycle ci-dessus avec une nouvelle valeur pour la résistance du rotor tant que la valeur prédéterminée ($i_s^{ref}$) pour le courant stator n'a pas été atteinte.

Les trois blocs B1, B2, B3 sont notamment intégrés dans les modules M1 à M5 du système de commande décrit ci-dessus.
Le bloc B1 est par exemple exécuté dans le module M2 permettant le calcul des tensions de commande.
Le bloc B2 est par exemple exécuté dans le module M2 de calcul des tensions.
Le bloc B3 est par exemple exécuté dans le module M5 permettant de traiter le courant stator acquis lors des mesures et d'en déduire la nouvelle valeur théorique $\hat{R}_r$ à affecter à la résistance du rotor selon la solution de recherche choisie (voir ci-dessous).
Une deuxième alternative illustrée par la figure 3B consiste à suivre le cycle suivant :

- Acquérir par mesure une tension de mesure référencée $u_s^{mes}$ pour laquelle le courant stator Is est égal à la valeur prédéterminée de référence, c'est-à-dire par exemple $i_s = 0$ ;

- Affecter dans un premier bloc B10 une première valeur théorique $\hat{R}_r$ en entrée de la loi de commande (par exemple comme décrit ci-dessus) à la variable de résistance du rotor ;

- Déterminer dans un bloc B20 la tension stator de référence $u_s^{ref}$ à partir de cette première valeur théorique $\hat{R}_r$ affectée à la résistance du rotor ;

- Comparer dans un bloc B30 la tension stator de référence $u_s^{ref}$ à la tension mesurée $u_s^{mes}$ acquise initialement ;

- Recommencer le cycle ci-dessus avec une nouvelle valeur pour la résistance du rotor tant que les deux tensions ne sont pas égales. La nouvelle valeur théorique $\hat{R}_r$ affectée à la résistance rotorique est déterminée en fonction du résultat de la comparaison entre les deux tensions.

L'acquisition de la tension $u_s^{mes}$ opérée initialement peut être mise en oeuvre selon deux principes distincts :

- En mettant le moteur en roue libre, c'est-à-dire que la tension appliquée au moteur n'est pas commandée ;

- En régulant le courant stator à une valeur nulle, la tension appliquée au moteur est alors calculée par une boucle de régulation sur les courants.

En théorie, la valeur prédéterminée $i_s^{ref}$ de courant stator $i_s$ à obtenir qui correspond à la valeur exacte de la résistance du rotor $\hat{R}_r$ est proche de zéro, préférentiellement égale à zéro. Autrement dit, lorsque la résistance du rotor est à sa valeur exacte, le courant stator $i_s$ obtenu lors de la mise en place de la solution de l'invention est à cette valeur proche de zéro, typiquement Le courant nominal divisé par 50, préférentiellement nulle.
Pour optimiser la recherche de la valeur exacte de la résistance du rotor $\hat{R}_r$ plusieurs algorithmes peuvent être mis en place pour converger vers une valeur précise de la résistance rotorique $R_r$. De manière non limitative :

- Une première solution consiste à employer un principe de dichotomie.

- Une deuxième solution consiste à mettre en place une méthode dite du gradient.

Dans la première solution, utilisant un principe de dichotomie, les paramètres employés sont RMAX, RMIN qui correspondent aux bornes extrêmes de chaque intervalle dans lequel la valeur de la résistance rotorique est cherchée et un nombre N d'itérations. Par principe, à chaque nouvelle itération (c'est-à-dire à chaque nouveau cycle débutant par l'attribution d'une nouvelle valeur $\hat{R}_r$ à la résistance rotorique), la largeur de l'intervalle des valeurs possibles à attribuer la résistance rotorique est divisée par deux. Lorsque le nombre d'itérations est atteint, la valeur de la résistance rotorique se trouve dans le dernier intervalle exploré. Plus celui-ci est restreint, plus la valeur sera précise. Le principe est illustré plus précisément sur la figure 4.

Ces deux solutions de recherche peuvent s'appliquer aux deux alternatives décrites ci-dessus, seule la contrainte d'arrêt de la recherche étant différente (égalité $i_S = i_S^{ref}$ $i_s$ pour la première alternative et égalité $u_S^{ref} = u_S^{mes}$ ).

A titre d'exemple et de manière non limitative, en référence à la figure 4, pour la première alternative décrite ci-dessus en liaison avec la figure 3A, l'algorithme de recherche par dichotomie comporte les différents blocs suivants :

- On définit les paramètres RMAX, RMIN dont les valeurs sont initialisées à des valeurs déterminées pour définir un intervalle de recherche ; R0 est également choisi avec une valeur comprise dans l'intervalle RMAX et RMIN;

- Le bloc B100 est un bloc de traitement qui correspond au bloc B3 décrit ci-dessus dans le processus global de recherche. C'est dans ce bloc qu'il est déterminé si la recherche est poursuivie ou non en fonction de la comparaison entre la valeur du courant stator $i_s$ et la valeur $i_S^{ref}$ ;

- Le bloc B200 correspond à un bloc de test pour tester si la valeur du courant $i_s$ est supérieure à zéro ;

- Si le courant $i_s$ est supérieur à zéro, le bloc B300 consiste à remplacer la valeur de RMAX par R0; R0=(RMAX+RMIn)/2

- Si le courant $i_s$ est inférieur à zéro, le bloc B400 consiste à remplacer la valeur de RMIN par R0; R0=(RMAX+RMIN)/2

- La bloc B500 correspond à un bloc de fin d'une itération, avant une nouvelle itération avec la nouvelle valeur affectée à R0.

La figure 5 illustre ainsi le principe du procédé d'identification de l'invention, utilisant une recherche par dichotomie. Le nombre d'itérations est représenté en abscisse et la valeur affectée à la résistance rotorique $R_r$ mise à jour après chaque itération est représentée en ordonné. On peut voir une convergence vers une valeur précise de la résistance rotorique $R_r$ au bout de cinq itérations.

La deuxième solution de recherche évoquée ci-dessus, consiste à faire varier la valeur affectée à la résistance rotorique $R_r$ en augmentation ou en diminution selon la variation du courant stator Is obtenu à chaque nouvelle itération. Cette méthode étant aisément compréhensible, elle n'est pas détaillée dans la présente demande.

On comprend de ce qui précède que la solution de l'invention pour identifier la résistance du rotor d'un moteur électrique présente un certain nombre d'avantages, parmi lesquels :

- Une certaine simplicité car le procédé s'intègre facilement dans la loi de commande du moteur électrique ;

- Le procédé peut être exécuté une fois pour toute lors de la phase de paramétrage du variateur de vitesse avec son moteur électrique ;

- La solution ne nécessite pas l'emploi d'un capteur de vitesse sur le moteur électrique et peut donc fonctionner en boucle ouverte.

**Revendications**

1. Procédé d'identification d'une valeur de résistance ($R_r$) du rotor d'un moteur électrique (M) à induction, **caractérisé en ce qu'**il comporte les étapes suivantes :

   a) Détermination d'une tension de référence $(u_S^{ref})$ en fonction d'une valeur ($\hat{R}_r$) choisie pour la résistance du rotor du moteur électrique,
   b) Application d'une tension de commande ($u_s$) au moteur électrique, ladite tension de commande étant déterminée à partir de ladite tension de référence $(u_S^{ref})$,
   c) Acquisition des valeurs des courants ($i_1$, $i_2$, $i_3$) mesurés dans les trois phases du moteur électrique de manière à en déduire un courant stator (ls) du moteur électrique,
   d) Comparaison du courant stator ($i_s$) obtenu avec une valeur prédéterminée $(i_S^{ref})$,
   e) Correction de ladite valeur ($\hat{R}_r$) utilisée pour la résistance ($R_r$) du rotor et application des étapes a) à d) jusqu'à obtenir un courant stator ($i_s$) égal à ladite valeur prédéterminée.

2. Procédé d'identification d'une valeur de résistance ($R_r$) du rotor d'un moteur électrique (M) à induction, **caractérisé en ce qu'**il comporte les étapes suivantes :

   a) Détermination d'une tension de mesure $(u_S^{mes})$ pour laquelle un courant stator ($i_s$) représentatif des courants ($i_1$, $i_2$, $i_3$) mesurés dans les trois phases du moteur électrique est égal à une valeur prédéterminée $(i_S^{ref})$,
   b) Détermination d'une tension de référence $(u_S^{ref})$ en fonction d'une valeur ($\hat{R}_r$) choisie pour la résistance du rotor du moteur électrique,
   c) Comparaison de ladite tension de référence avec la tension de mesure,
   d) Correction de ladite valeur ($\hat{R}_r$) utilisée pour la résistance ($R_r$) du rotor et application des étapes a) à c) jusqu'à obtenir une égalité entre ladite tension de référence et la tension de mesure.

3. Procédé selon la revendication 1 ou 2, **caractérisée en ce que** ladite valeur prédéterminée $(i_S^{ref})$ correspond à une valeur nulle ou proche de zéro.

4. Procédé selon la revendication 3, **caractérisé en ce qu'**il est mis en oeuvre selon un principe de dichotomie comprenant plusieurs itérations successives et dans lequel, à chaque itération, un intervalle dans lequel se trouve la valeur recherchée pour la résistance du rotor est divisée par deux.

5. Procédé selon la revendication 3, **caractérisé en ce qu'**il est mis en oeuvre selon un principe de gradient comprenant plusieurs itérations successives et dans lequel la valeur ($\hat{R}_r$) choisie pour la résistance du rotor est modifiée à chaque itération selon le sens du résultat de l'étape de comparaison.

6. Système d'identification d'une valeur de résistance ($R_r$) du rotor d'un moteur électrique (M) à induction, **caractérisé en ce qu'**il comporte :

   a) Un module de détermination d'une tension de référence $(u_S^{ref})$ en fonction d'une valeur ($\hat{R}_r$) choisie pour la résistance du rotor du moteur électrique,
   b) Un module d'application de tensions de commande ($u_s$) au moteur électrique, lesdites tensions de commande étant déterminées à partir de ladite tension de référence $(u_S^{ref})$,
   c) Un module d'acquisition des valeurs des courants ($i_1$, $i_2$, $i_3$) mesurés dans les trois phases du moteur électrique de manière à en déduire un courant stator ($i_s$) du moteur électrique,
   d) Un module de comparaison du courant stator ($i_s$) obtenu avec une valeur prédéterminée $(i_S^{ref})$,
   e) Un module de correction de ladite valeur ($\hat{R}_r$) utilisée pour la résistance ($R_r$) du rotor et exécution des modules a) à d) jusqu'à obtenir un courant stator égal à ladite valeur prédéterminée $(i_S^{ref})$.

7.  Système d'identification d'une valeur de résistance ($R_r$) du rotor d'un moteur électrique (M) à induction, **caractérisé en ce qu'**il comporte :

    a) Un module de détermination d'une tension de mesure $(u_S^{mes})$ pour laquelle un courant stator ($i_s$) représentatif des courants ($i_1$, $i_2$, $i_3$) mesurés dans les trois phases du moteur électrique est égal à une valeur prédéterminée $(i_S^{ref})$,

    b) Un module de détermination d'une tension de référence $(u_S^{ref})$ en fonction d'une valeur ($\hat{R}_r$) choisie pour la résistance du rotor du moteur électrique,
    c) Un module de comparaison de ladite tension de référence avec la tension de mesure,
    d) Un module de correction de ladite valeur ($\hat{R}_r$) utilisée pour la résistance ($R_r$) du rotor et exécution des modules a) à c) jusqu'à obtenir une égalité entre ladite tension de référence et la tension de mesure.

8.  Système selon la revendication 6 ou 7, **caractérisée en ce que** ladite valeur prédéterminée correspond à une valeur nulle ou proche de zéro.

9.  Système selon la revendication 8, **caractérisé en ce qu'**il est configuré pour fonctionner selon un principe de dichotomie comprenant plusieurs itérations successives et dans lequel, à chaque itération, un intervalle dans lequel se trouve la valeur recherchée pour la résistance du rotor est divisée par deux.

10. Système selon la revendication 8, **caractérisé en ce qu'**il est configuré pour fonctionner selon un principe de gradient comprenant plusieurs itérations successives et dans lequel la valeur ($\hat{R}_r$) choisie pour la résistance du rotor est modifiée à chaque itération selon le sens du résultat de l'étape de comparaison.

11. Variateur de vitesse destiné à la commande d'un moteur électrique, **caractérisé en ce qu'**il comporte un système de commande comprenant un système d'identification conforme à celui défini dans l'une des revendications 6 à 10.

**Patentansprüche**

1.  Verfahren zur Identifizierung eines Widerstandswertes ($R_r$) des Rotors eines elektrischen Induktionsmotors (M), **dadurch gekennzeichnet, dass** es die folgenden Schritte umfasst:

    a) Bestimmung einer Referenzspannung $(u_S^{ref})$ in Abhängigkeit von einem gewählten Wert ($\hat{R}_r$) für den Widerstand des Rotors des Elektromotors,
    b) Anlegen einer Steuerspannung ($u_s$) an den Elektromotor, wobei die Steuerspannung aus der Referenzspannung $(u_S^{ref})$ bestimmt wird,
    c) Erfassung der Werte der Ströme ($i_1$, $i_2$, $i_3$), die in den drei Phasen des Elektromotors gemessen werden, um daraus einen Statorstrom ($i_s$) des Elektromotors abzuleiten,
    d) Vergleich des erhaltenen Statorstroms ($i_s$) mit einem vorbestimmten Wert $(i_S^{ref})$,
    e) Korrektur des für den Widerstand ($R_r$) des Rotors verwendeten Wertes ($\hat{R}_r$) und Anwendung der Schritte a) bis d), bis ein Statorstrom ($i_s$) erhalten wird. der gleich dem vorbestimmten Wert ist.

2.  Verfahren zur Identifizierung eines Widerstandswertes ($R_r$) des Rotors eines elektrischen Induktionsmotors (M), **dadurch gekennzeichnet, dass** es die folgenden Schritte umfasst:

    a) Bestimmung einer Messspannung $(u_S^{mes})$, für welche ein Statorstrom ($i_s$), der für die in den drei Phasen des Elektromotors gemessenen Ströme ($i_1$, $i_2$, $i_3$) repräsentativ ist, gleich einem vorbestimmten Wert $(i_S^{ref})$ ist,

    b) Bestimmung einer Referenzspannung $(u_S^{ref})$ in Abhängigkeit von einem für den Widerstand des Rotors des Elektromotors gewählten Wert ($\hat{R}_r$),
    c) Vergleich der Referenzspannung mit der Messspannung,

d) Korrektur des für den Widerstand ($R_r$) des Rotors verwendeten Wertes ($\hat{R}_r$) und Anwendung der Schritte a) bis c), bis eine Gleichheit zwischen der Referenzspannung und der Messspannung erhalten wird.

3. Verfahren nach Anspruch 1 oder 2, **dadurch gekennzeichnet, dass** der vorbestimmte Wert $\left(i_S^{ref}\right)$ einem Wert von null oder nahe bei null entspricht.

4. Verfahren nach Anspruch 3, **dadurch gekennzeichnet, dass** es gemäß einem Dichotomieprinzip durchgeführt wird, das mehrere aufeinander folgende Iterationen umfasst und bei dem in jeder Iteration ein Intervall, in dem sich der gesuchte Wert für den Widerstand des Rotors befindet, halbiert wird.

5. Verfahren nach Anspruch 3, **dadurch gekennzeichnet, dass** es gemäß einem Gradientenprinzip durchgeführt wird, das mehrere aufeinander folgende Iterationen umfasst und bei dem der für den Widerstand des Rotors gewählte Wert ($\hat{R}_r$) bei jeder Iteration in Abhängigkeit von der Richtung des Ergebnisses des Vergleichsschrittes geändert wird.

6. System zur Identifizierung eines Widerstandswertes ($R_r$) des Rotors eines elektrischen Induktionsmotors (M), **dadurch gekennzeichnet, dass** es aufweist:

   a) ein Modul zur Bestimmung einer Referenzspannung $\left(u_S^{ref}\right)$ in Abhängigkeit von einem gewählten Wert ($\hat{R}_r$) für den Widerstand des Rotors des Elektromotors,

   b) ein Modul zum Anlegen von Steuerspannungen ($u_s$) an den Elektromotor, wobei die Steuerspannungen aus der Referenzspannung $\left(u_S^{ref}\right)$ bestimmt werden,

   c) ein Modul zur Erfassung der Werte der Ströme ($i_1$, $i_2$, $i_3$), die in den drei Phasen des Elektromotors gemessen werden, um daraus einen Statorstrom ($i_s$) des Elektromotors abzuleiten,

   d) ein Modul zum Vergleich des erhaltenen Statorstroms ($i_s$) mit einem vorbestimmten Wert $\left(i_S^{ref}\right)$,

   e) ein Modul zur Korrektur des für den Widerstand ($R_r$) des Rotors verwendeten Wertes ($\hat{R}_r$) und Ausführung der Module a) bis d), bis ein Statorstrom erhalten wird. der gleich dem vorbestimmten Wert $\left(i_S^{ref}\right)$ ist.

7. System zur Identifizierung eines Widerstandswertes ($R_r$) des Rotors eines elektrischen Induktionsmotors (M), **dadurch gekennzeichnet, dass** es aufweist:

   a) ein Modul zur Bestimmung einer Messspannung $\left(u_S^{mes}\right)$, für welche ein Statorstrom ($i_s$), der für die in den drei Phasen des Elektromotors gemessenen Ströme ($i_1$, $i_2$, $i_3$) repräsentativ ist, gleich einem vorbestimmten Wert $\left(i_S^{ref}\right)$ ist,

   b) ein Modul zur Bestimmung einer Referenzspannung $\left(u_S^{ref}\right)$ in Abhängigkeit von einem für den Widerstand des Rotors des Elektromotors gewählten Wert ($\hat{R}_r$),

   c) ein Modul zum Vergleich der Referenzspannung mit der Messspannung,

   d) ein Modul zur Korrektur des für den Widerstand ($R_r$) des Rotors verwendeten Wertes ($\hat{R}_r$) und Ausführung der Module a) bis c), bis eine Gleichheit zwischen der Referenzspannung und der Messspannung erhalten wird.

8. System nach Anspruch 6 oder 7, **dadurch gekennzeichnet, dass** der vorbestimmte Wert einem Wert von null oder nahe bei null entspricht.

9. System nach Anspruch 8, **dadurch gekennzeichnet, dass** es dafür ausgelegt ist, gemäß einem Dichotomieprinzip zu arbeiten, das mehrere aufeinander folgende Iterationen umfasst und bei dem in jeder Iteration ein Intervall, in dem sich der gesuchte Wert für den Widerstand des Rotors befindet, halbiert wird.

10. System nach Anspruch 8, **dadurch gekennzeichnet, dass** es dafür ausgelegt ist, gemäß einem Gradientenprinzip zu arbeiten, das mehrere aufeinanderfolgende Iterationen umfasst und bei dem der für den Widerstand des Rotors gewählte Wert ($\hat{R}_r$) bei jeder Iteration in Abhängigkeit von der Richtung des Ergebnisses des Vergleichsschrittes geändert wird.

11. Umrichter, welcher zur Steuerung eines Elektromotors bestimmt ist, **dadurch gekennzeichnet, dass** er ein Steuerungssystem aufweist, das ein System zur Identifizierung umfasst, das mit demjenigen konform ist, das in einem der Ansprüche 6 bis 10 definiert ist.

**Claims**

1. Method for identifying a resistance value ($R_r$) of the rotor of an electric induction motor (M), **characterized in that** it includes the following steps:

   a) Determining a reference voltage $\left(u_S^{ref}\right)$ on the basis of a chosen value ($\hat{R}_r$) for the resistance of the rotor of the electric motor,
   b) Applying a control voltage ($u_s$) to the electric motor, said control voltage being determined on the basis of said reference voltage $\left(u_S^{ref}\right)$,
   c) Acquiring the values of the currents ($i_1$, $i_2$, $i_3$) measured in the three phases of the electric motor, so as to deduce a stator current (Is) of the electric motor therefrom,
   d) Comparing the obtained stator current ($i_s$) with a predetermined value $\left(i_S^{ref}\right)$,
   e) Correcting said value ($\hat{R}_r$) used for the resistance ($R_r$) of the rotor and applying steps a) to d) until obtaining a stator current ($i_s$) equal to said predetermined value.

2. Method for identifying a resistance value ($R_r$) of the rotor of an electric induction motor (M), **characterized in that** it includes the following steps:

   a) Determining a measurement voltage $\left(u_S^{mes}\right)$ for which a stator current ($i_s$) representative of the currents ($i_1$, $i_2$, $i_3$) measured in the three phases of the electric motor is equal to a predetermined value $\left(i_S^{ref}\right)$,
   b) Determining a reference voltage $\left(u_S^{ref}\right)$ on the basis of a chosen value ($\hat{R}_r$) for the resistance of the rotor of the electric motor,
   c) Comparing said reference voltage with the measurement voltage,
   d) Correcting said value ($\hat{R}_r$) used for the resistance ($R_r$) of the rotor and applying steps a) to c) until obtaining equality between said reference voltage and the measurement voltage.

3. Method according to Claim 1 or 2, **characterized in that** said predetermined value $\left(i_S^{ref}\right)$ corresponds to a value of zero or close to zero.

4. Method according to Claim 3, **characterized in that** it is implemented in accordance with a dichotomic principle comprising a plurality of successive iterations and in which, at each iteration, an interval in which the sought value for the resistance of the rotor is situated is divided by two.

5. Method according to Claim 3, **characterized in that** it is implemented in accordance with a gradient principle comprising a plurality of successive iterations and in which the chosen value ($\hat{R}_r$) for the resistance of the rotor is modified at each iteration depending on the meaning of the result of the comparison step.

6. System for identifying a resistance value ($R_r$) of the rotor of an electric induction motor (M), **characterized in that** it includes:

   a) A module for determining a reference voltage $\left(u_S^{ref}\right)$ on the basis of a chosen value ($\hat{R}_r$) for the resistance of the rotor of the electric motor,
   b) A module for applying control voltages ($u_s$) to the electric motor, said control voltages being determined on the basis of said reference voltage $\left(u_S^{ref}\right)$,
   c) A module for acquiring the values of the currents ($i_1$, $i_2$, $i_3$) measured in the three phases of the electric motor, so as to deduce a stator current ($i_s$) of the electric motor therefrom,
   d) A module for comparing the obtained stator current ($i_s$) with a predetermined value $\left(i_S^{ref}\right)$,

e) A module for correcting said value ($\hat{R}_r$) used for the resistance ($R_r$) of the rotor and for executing modules a) to d) until obtaining a stator current equal to said predetermined value $(i_S^{ref})$.

**7.** System for identifying a resistance value ($R_r$) of the rotor of an electric induction motor (M), **characterized in that** it includes:

a) A module for determining a measurement voltage $(u_S^{mes})$ for which a stator current ($i_s$) representative of the currents ($i_1$, $i_2$, $i_3$) measured in the three phases of the electric motor is equal to a predetermined value $(i_S^{ref})$,

b) A module for determining a reference voltage $(u_S^{ref})$ on the basis of a chosen value ($\hat{R}_r$) for the resistance of the rotor of the electric motor,

c) A module for comparing said reference voltage with the measurement voltage,

d) A module for correcting said value ($\hat{R}_r$) used for the resistance ($R_r$) of the rotor and for executing modules a) to c) until obtaining equality between said reference voltage and the measurement voltage.

**8.** System according to Claim 6 or 7, **characterized in that** said predetermined value corresponds to a value of zero or close to zero.

**9.** System according to Claim 8, **characterized in that** it is configured to operate in accordance with a dichotomic principle comprising a plurality of successive iterations and in which, at each iteration, an interval in which the sought value for the resistance of the rotor is situated is divided by two.

**10.** System according to Claim 8, **characterized in that** it is configured to operate in accordance with a gradient principle comprising a plurality of successive iterations and in which the chosen value ($\hat{R}_r$) for the resistance of the rotor is modified at each iteration depending on the meaning of the result of the comparison step.

**11.** Variable speed drive intended for the control of an electric motor, **characterized in that** it includes a control system comprising an identification system in accordance with the one defined in one of Claims 6 to 10.

**Fig. 1**

**Fig. 2**

**Fig. 3A**

B1

B2

$u_S^{ref}$

$I_S^{ref} = 0$

$\hat{R}_r$

B3

$i_S = i_S^{ref}$ ?

$i_S$

$u_S$

M

$i_S$

**Fig. 3B**

B10

B20

$u_S^{ref}$

$i_S^{ref} = 0$

$\hat{R}_r$

B30

$u_S^{ref} = u_S^{mes}$ ?

$u_S^{mes}$

$i_S$

$u_S$

M

$i_S$

**Fig. 4**

B100 → B200 → B300 → B500

B200 → B400 → B500

**Fig. 5**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• EP 1713173 B1

**Littérature non-brevet citée dans la description**

• Parallel estimation of rotor resistance and speed for sensorless vector controlled induction motor drive. **DIAB AHMED A ZAKI et al.** 2016 17TH International Conference of young specialists on Micro/nanotechnologies and electron devices (EDM). IEEE, 30 Juin 2016, 389-394